# EUROPÄISCHE PATENTSCHRIFT

(11) **EP 3 327 931 B1**
(45) Veröffentlichungstag und Bekanntmachung des Hinweises auf die Patenterteilung: **16.06.2021**
(21) Anmeldenummer: 18151721.0
(22) Anmeldetag: 16.05.2012
(51) Int. Cl.: H03G 3/32, H03G 5/02, H03G 5/16

(54) **TONWIEDERGABEVORRICHTUNG MIT HÖRSZENARIOSIMULATION**
SOUND REPRODUCTION DEVICE WITH SCENARIO SIMULATION
DISPOSITIF DE REPRODUCTION DU SON À SIMULATION DE SCÉNARIO D'ÉCOUTE

(30) Priorität: 25.05.2011 DE 102011076484
(43) Veröffentlichungstag der Anmeldung: 30.05.2018
(62) Teilanmeldung aus: 12720896.5
(73) Patentinhaber: Fraunhofer-Gesellschaft zur Förderung der angewandten Forschung e.V., 80686 München (DE)
(72) Erfinder: APPELL, Jens Ekkehart, 26121 Oldenburg (DE); RENNIES-HOCHMUTH, Jan, 26121 Oldenburg (DE)
(74) Vertreter: Pfitzner, Hannes

(56) Entgegenhaltungen:
- EP-A2- 1 744 590
- DE-A1- 19 737 732
- US-A1- 2008 212 788

## Beschreibung

Die vorliegende Anmeldung bezieht sich auf Tonwiedergabevorrichtungen, auf eine Schnittstelle zum Austausch von benutzerdefinierten, Hörszenario-abhängigen Wiedergabeparametereinstellungen, auf ein Audiosystem mit einer solchen Schnittstelle, auf eine Datenstruktur für eine Wiedergabeparametereinstellung und eine zugeordnete Hörszenarioinformation, auf ein Verfahren zum Einlernen von benutzerdefinierten und Hörszenario-abhängigen Wiedergabeparametereinstellungen für eine Tonwiedergabevorrichtung und auf ein entsprechendes Computerprogramm.

Die Wiedergabe von akustischen Signalen, die an einem anderen Ort und/oder zu einer anderen Zeit aufgenommen wurden, spielt in vielen Bereichen des täglichen Lebens eine große Rolle. Der Zweck einer solchen Tonwiedergabe kann zum Beispiel darin bestehen, den Hörer mit Informationen zu versorgen oder ihn zu unterhalten. Die Begriffe "Tonwiedergabe" und "Tonwiedergabevorrichtung" beziehen sich auf die Wiedergabe von Schall bzw. akustischen Signalen im Allgemeinen. Um die große Anzahl an unterschiedlichen Anwendungssituationen einer Tonwiedergabe abzudecken, wurde in der Vergangenheit eine Vielzahl von Aufnahme-, Speicher- und Wiedergabevorrichtungen entwickelt.

Die EP 1744590 A2 beschreibt ein Hörgerät mit Anpassung einer Klangcharakteristik. In diesem Zusammenhang ist auch noch auf die DE 19737732 A1 und die US 2008/212788 A1 hinzuweisen.

Die Wiedergabe eines zuvor bzw. an einem anderen Ort aufgenommen akustischen Signals unterscheidet sich typischerweise von dem Originalsignal, was auf die beschränkenden Eigenschaften der verwendeten Aufnahme-, Speicher- und Wiedergabevorrichtungen zurückzuführen ist. Die meisten gebräuchlichen Tonwiedergabevorrichtungen ermöglichen es einem Nutzer oder Hörer, die Tonwiedergabe an seine Präferenzen anzupassen. Ein Beispiel für eine derartige Anpassung ist die Einstellung der Lautstärke der Tonwiedergabe. Auch die Klangeigenschaften können bei den meisten Tonwiedergabevorrichtungen eingestellt werden, was sich auf die unterschiedlichen Frequenzbereiche des wiederzugebenden akustischen Signals auswirkt, so dass der Nutzer bestimmte Frequenzbereiche des akustischen Signals hervorheben kann. Andere Frequenzbereiche können dagegen abgeschwächt wiedergegeben werden. Derartige Klangpräferenzen, z.B. bezüglich des Frequenzgangs von Musik, sind vom Nutzer bzw. Hörer abhängig.

Bestehende Tonwiedergabevorrichtungen verfügen über relativ begrenzte Möglichkeiten der Klanganpassung, wie z.B. Lautheit (engl. "Loudness"), Bässe und Höhen, die über eine Benutzerschnittstelle der Tonwiedergabevorrichtung eingestellt werden können. Die Benutzerschnittstelle kann z.B. elektromechanische Einstellknöpfe oder-tasten oder anderweitige Regelungsoptionen für den Nutzer umfassen. Der Nutzer kann auf diese Weise die Wiedergabeparameter der Tonwiedergabe einstellen und auf diese Weise an unterschiedliche akustische Signale anpassen. Dabei kann die Art des akustischen Signals eine Rolle spielen, wobei unter der Art des akustischen Signals eine Klassifizierung der mittels des akustischen Signals übertragenen Information gemeint sein kann. Beispiele für mögliche Signalarten sind: Popmusik, Rockmusik, Sprache. Des Weiteren kommt es auch relativ häufig vor, dass der Nutzer die Wiedergabeparameter im Hinblick auf externe, störende Geräusche oder Einflüsse so anpasst, dass das gewünschte akustische Signal sich ausreichend von den störenden Geräuschen abhebt, um von diesen unterschieden werden zu können.

Sowohl die Eigenschaften des wiederzugebenden akustischen Signals als auch die Eigenschaften der externen Störgeräusche ändern sich typischerweise über der Zeit. Sie sind also typischerweise nicht statisch sondern dynamisch. Zum Beispiel ändern sich in einem Automobil die akustischen Bedingungen (wie etwa Nebengeräusche) ständig während der Fahrt, so dass unterschiedliche Verdeckungswirkungen mit der eingestellten Klangeinstellung interagieren und die Klangpräferenzen damit von der Fahrsituation abhängen. Unter Verdeckung (auch Maskierungseffekt genannt) versteht man eine Eigenschaft des menschlichen Gehörs, wonach in einem simultanen oder zeitlich versetzten Geräusch bzw. Gesamtklang bestimmte Signalanteile nicht oder nur verändert wahrgenommen werden können. Somit kann ein starkes Störgeräusch bewirken, dass der Hörer das Nutzsignal kaum noch wahrnehmen kann, selbst wenn das Störgeräusch hauptsächlich in einem begrenzten Frequenzbereich vorliegt.

Das Beispiel der Tonwiedergabe in einem Automobil wieder aufgreifend, kann es vorkommen, dass vom Nutzer bei unterschiedlichen Fahrsituationen andere Einstellungen gewünscht werden. In diesem Fall müssen die Wiedergabeparameter vom Nutzer für die neue Fahrsituation neu eingestellt werden. Der Nutzer muss also tatsächlich in der Fahrsituation sein, um den Klang an diese Situation anzupassen.

Einige Entwicklungen auf dem Gebiet der Tonwiedergabevorrichtungen in Kraftfahrzeugen ermöglichen es, bestimmte Wiedergabeparameter automatisch in Abhängigkeit von der Fahrsituation einzustellen. Zum Beispiel passen einige Autoradios die Lautstärke an die Geschwindigkeit an, d.h. mit steigender Geschwindigkeit des Automobils wird die Lautstärke des Autoradios erhöht. Zu diesem Zweck weisen derartige Autoradios häufig eine Schnittstelle zu einem Bordcomputer oder zu einem Tachometer des Automobils auf, um die momentane Geschwindigkeit des Automobils erfassen zu können. Das Ausmaß der Lautstärkeerhöhung kann dabei fest vorgegeben sein, z.B. in Form einer Kennlinie der Lautstärkeerhöhung über der Geschwindigkeit. Andere Systeme sind in der Lage, die aktuelle Fahrsituation zu speichern und die vom Nutzer gewählten Klangeinstellungen den Situationen zuzuordnen. Befindet sich das Automobil zu einem späteren Zeitpunkt in einer ähnlichen Fahrsituation, so wird die gespeicherte Klangeinstellung abgerufen und auf die Tonwiedergabe des Nutzsignals angewendet. Das US-Patent Nr. 5,844,992 beschreibt zum Beispiel ein Fuzzy-Logic-Gerät für automatische Klangsteuerung, um einen Klangpegel mithilfe automatischer Steuerungen derart einzustellen, dass die Umgebung und die Betriebsbedingungen, in welcher ein Audiogerät betrieben wird, berücksichtigen zu können. Das Steuergerät kann personalisiert werden, indem ein Hörer persönliche Einstellungen eingibt. Zu diesem Zweck weist das Audiogerät Bedienknöpfe zum Variieren der Ausgabeverstärkung oder der Bässe-Höhen-Balance auf, welche es dem Hörer ermöglichen, persönliche Einstellungen vorzunehmen. Die Steuerung weist Konvertierungs- und Steuermittel auf, die diese persönlichen Einstellungen scannen und sich diesen entsprechend anpassen. Diese Selbstanpassung kann eine nach der anderen vorgenommen werden bei jeder definierten persönlichen Einstellung. Genauer können die Konvertierungs- und Steuermittel die Kumulierung der persönlichen Einstellungen, die von dem Hörer durchgeführt wurden, in Betracht ziehen. Die Steuerung kann somit graduell die persönlichen Wünsche des Hörers in der Umgebung, in der das Audiogerät benutzt wird, lernen. Bei einem solchen System ist es aber erforderlich, dass der Nutzer zumindest einmal in einer bestimmten Fahrsituation war und den Klang mittels einer Wiedergabeparametereinstellung an diese Fahrsituation angepasst hat.

Auch bei tragbaren Tonwiedergabevorrichtungen, wie Abspielgeräten für Dateien im MP3-Format, kann sich die Hörsituation ändern, da auch hier unterschiedliche Arten von Nutzsignalen wiedergegeben werden können und sich die Umgebungsgeräusche ändern können.

Es wäre wünschenswert, einem Benutzer einer Tonwiedergabevorrichtung die Möglichkeit zu geben, Wiedergabeparameter für unterschiedliche Hörsituationen nach individuellen Präferenzen einstellen zu können, und zwar unabhängig von einem aktuellen Vorliegen der jeweiligen Hörsituation. Es wäre auch wünschenswert, z.B. schwerhörigen Personen eine Möglichkeit zu bieten, Wiedergabeparametereinstellungen für eine Tonwiedergabevorrichtung auf einfache und bequeme Weise dauerhaft an unterschiedliche Hörsituationen anzupassen.

Gemäß Ausführungsbeispielen der hierin vorgestellten Lehre umfasst eine Tonwiedergabevorrichtung eine Signalverarbeitungskette, eine Simulationsszenario-Einrichtung, eine Benutzerschnittstelle, einen Signalmodifizierer und einen Speicher. Die Signalverarbeitungskette ist konfiguriert, ein Nutzsignal für eine Wiedergabe an einen Hörer aufzubereiten. Die Simulationsszenario-Einrichtung ist konfiguriert, eine Hörszenarioinformation zu einem simulierten Hörszenario bereitzustellen, wobei das simulierte Hörszenario eine durch den Hörer erfolgende Wahrnehmung der Wiedergabe des Nutzsignals beeinflusst und/oder eine Nutzsignalart definiert. Die Benutzerschnittstelle ist konfiguriert, Wiedergabeparametereinstellungen von einem Benutzer zu erfassen, die eine individuelle Präferenz des Hörers angesichts des simulierten Hörszenarios abbilden. Der Signalmodifizierer ist konfiguriert, die Wiedergabeparametereinstellungen zu empfangen und die Wiedergabe des Nutzsignals nach Maßgabe der Wiedergabeparametereinstellungen zu modifizieren. Der Speicher ist konfiguriert zum Speichern der Wiedergabeparametereinstellung und der Hörszenarioinformation mit Bezug zueinander.

Die Tonwiedergabevorrichtung kann im Zusammenhang mit einer Simulation eines Hörszenarios verwendet werden. Ein Hörszenario beschreibt die Wahrnehmung des Nutzsignals durch den Hörer anhand eines oder mehrerer Merkmale. Das Hörszenario kann sich auf das Nutzsignal, externe Geräusche oder akustische Signale oder sowohl auf das Nutzsignal als auch auf die externen Geräusche/akustische Signale beziehen. Darüber hinaus kann das Hörszenario sich auch auf weitere Aspekte der Wahrnehmung durch den Hörer beziehen, wie z.B. Informationen über die akustischen Verhältnisse des Umfelds, in dem die Wiedergabe stattfindet (z.B. Nachhall, Mono-, Stereo, 5.1- oder 7.1-Wiedergabe, Kopfhörer, etc.). Falls das Hörszenario die Nutzsignalart definiert, kann für die Zwecke der Simulation ein passendes Nutzsignal bereitgestellt und über die Signalverarbeitungskette wiedergegeben werden. Eine andere Möglichkeit ist die, dass die Simulationsszenario-Schnittstelle die Nutzsignalart eines momentan wiedergegebenen Nutzsignals bestimmt und anhand dieser Information (und eventueller weiterer Informationen) das passende Hörszenario auswählt. Auf diese Weise können die vom Benutzer vorgenommenen Einstellungen der Wiedergabeparameter den richtigen Hörszenarien zugeordnet werden. Der Hörer kann dieselbe Person wie oder eine andere Person als der Benutzer sein.

Die Wiedergabeparametereinstellung, die der Benutzer über die Benutzerschnittstelle vornehmen kann, kann direkt oder indirekt erfolgen. Eine direkte Wiedergabeparametereinstellung entspräche einer Einstellung der klassischen Parameter wie Lautstärke, Höhen, Tiefen, etc.. Die Anzahl der möglichen Parameter hat in den letzten Jahren durch z.B. Equalizer, Ex-Bass, "Meta"-Einstellungen wie Sprache, Rock, Jazz erheblich zugenommen. Unter einer indirekten Wiedergabeparametereinstellung werden Verfahren verstanden, bei denen der Nutzer entweder seine Wahrnehmung beschreibt, also etwa "zu scharf", bzw. diese skaliert, also z.B. von "zu weich" bis "zu scharf" in 10 Stufen, aus denen dann die verfügbaren üblichen Parameter abgeleitet werden, also z.B. die EqualizerEinstellungen. Andererseits könnten auch Tests mit dem Nutzer durchgeführt werden, wie etwa ein Sprachtest zum Prüfen der Verständlichkeit von Sprache, um daraus Parameter abzuleiten, die ein optimales Sprachverstehen erlauben.

Der Signalmodifizierer ermöglicht es dem Hörer, die Auswirkung der vorgenommenen Einstellungen der Wiedergabeparameter auf seine Wahrnehmung des Nutzsignals unmittelbar zu hören bzw. einzuschätzen. Insbesondere kann der Hörer feststellen, ob im Rahmen eines bestimmten Hörszenarios die gewählten Wiedergabeparameter eine Wiedergabe des Nutzsignals gemäß seinen individuellen Präferenzen ermöglichen. Angenommen, der Hörer ist insbesondere daran interessiert, dass Sprachnachrichten möglichst klar und verständlich wiedergegeben werden, so wird der Hörer die Wiedergabeparameter derart wählen, dass dieses Ziel erreicht wird. Handelt es sich bei dem Nutzsignal dagegen um Musik, so soll das Nutzsignal etwas leiser wiedergegeben werden, da der Hörer die Musik lediglich als Hintergrundmusik wünscht. Ein anderer Hörer könnte dagegen gerade die gegenteilige Präferenz haben, also eine relativ deutliche Wiedergabe von Musik und eine in den Hintergrund tretende Wiedergabe von Sprache.

Wie oben erwähnt, kann sich das Hörszenario auch auf unterschiedliche Störgeräusche oder -töne aus der Umgebung beziehen. Durch gleichzeitiges Wahrnehmen des Nutzsignals und der Störgeräusche kann der Hörer feststellen, ob sich mit den vorgenommenen Einstellungen der Wiedergabeparameter das Nutzsignal so gegenüber den Störgeräuschen verhält, wie er es wünscht. Gegebenenfalls kann der Benutzer über die Benutzerschnittstelle die Wiedergabeparameter ändern. Erfindungsgemäß beeinflusst der Signalmodifizierer lediglich die Wiedergabe des Nutzsignals, nicht jedoch die Wiedergabe des eventuellen Störgeräusches, das im Rahmen des simulierten Hörszenarios gemeinsam mit dem Nutzsignal wiedergegeben wird. Dies spiegelt die Tatsache wieder, dass der Benutzer während eines Normalbetriebs einer Tonwiedergabevorrichtung typischerweise keinen Einfluss auf die Störgeräusche hat, sondern lediglich die Wiedergabe des Nutzsignals entsprechend anpassen kann.

Durch das Speichern der Wiedergabeparametereinstellungen und der Hörszenarioinformation mit Bezug zueinander wird die individuelle Präferenz des Hörers zur Verwendung zu einem späteren Zeitpunkt konserviert. Die gespeicherte Hörszenarioinformation ermöglicht es, eine Abfrage des Speichers mit einer aktuellen Hörszenarioinformation durchzuführen, um auf diese Weise Wiedergabeparametereinstellungen aus dem Speicher abrufen zu können, die möglichst passend für das aktuell vorherrschende Hörszenario bzw. Hörsituation sind.

Die Simulationsszenario-Einrichtung kann eine Benutzerschnittstelle umfassen, die konfiguriert ist, die Hörszenarioinformation als Benutzereingabe zu erfassen. Die Benutzerschnittstelle für die Hörszenarioinformation kann mit der Benutzerschnittstelle für die Wiedergabeparametereinstellung zusammenfallen oder separat von dieser ausgeführt sein.

In einigen Ausführungsbeispielen kann die Benutzereingabe so verwendet werden, dass die Simulationsszenario-Einrichtung die Tonwiedergabeeinrichtung veranlasst, das der Hörszenarioinformation entsprechende simulierte Hörszenario umzusetzen, d.h. eine Simulation dieses Hörszenarios durchzuführen. Die Simulationszenario-Einrichtung kann also konfiguriert sein, das simulierte Hörszenario selbst zu erzeugen. Zu diesem Zweck kann über die Signalverarbeitungskette ein bestimmtes Nutzsignal ausgegeben werden, das der Nutzsignalart entspricht, die von dem simulierten Hörszenario definiert wird. Dementsprechend kann die Signalverarbeitungskette konfiguriert sein, ein Geräuschsignal für die Wiedergabe an den Hörer aufzubereiten, wobei das Geräuschsignal dem Hörszenario zugeordnet ist. Das zuvor erwähnte bestimmte Nutzsignal kann im Rahmen des Hörszenarios fest vorgegeben sein, oder es kann mittels einer sogenannten Genre-Information (z.B. Pop, Rock, Jazz, ...) aus verfügbaren Nutzsignalen ausgewählt werden. Genre-Informationen werden von einer Vielzahl von Schallsignalquellen zur Verfügung gestellt. Als Beispiele seien die ID3-Datenstruktur im Zusammenhang mit MP3-Dateien, die Möglichkeit der Identifizierung von Titeln einer CompactDisc (CD) mittels einer zentralen Datenbank (z.B. CompactDisc DataBase, CDDB) und die Ausstrahlung eines entsprechend Merkmals durch Radiosender im Rahmen eines Radiodatensystems wie dem "Radio Data System (RDS)" genannt. Alternativ oder zusätzlich zu der Berücksichtigung einer definierten Nutzsignalart können Stör- oder Nebengeräusche von dem simulierten Hörszenario berücksichtigt werden, so dass die Simulationsszenario-Einrichtung die Simulation einer Umgebung durchführt, in der derartige Stör- oder Nebengeräusche auftreten. Die Simulation kann die Wiedergabe von gespeicherten Klängen oder auch deren Erzeugung z.B. mittels eines Synthesizers umfassen. Die Simulationsszenario-Einrichtung kann einen Umgebungsgeräuschsimulator umfassen, der konfiguriert ist, ein Geräuschsignal auszugeben, das dem simulierten Hörszenario zugeordnet ist.

In anderen Ausführungsbeispielen als denen, die im vorherigen Absatz beschrieben wurden, wird die eigentliche Simulation des Hörszenarios außerhalb der Tonwiedergabevorrichtung durchgeführt. Dies kann zum Beispiel in der Form erfolgen, dass die Stör- und Nebengeräusche durch eine andere Tonwiedergabevorrichtung möglichst realitätsnah für den Hörer erzeugt werden. Der Benutzer kann die andere Tonwiedergabevorrichtung gemäß einem bestimmten Hörszenario entsprechend konfigurieren, zumindest was den Aspekt der Stör- oder Nebengeräusche angeht. Über die Benutzerschnittstelle der Simulationsszenario-Einrichtung der ersten Tonwiedergabevorrichtung (die für die Wiedergabe des Nutzsignals verwendet wird) kann der Benutzer dieselbe Hörszenarioinformation bezüglich des bestimmten Hörszenarios eingeben, damit diese Information beim Speichern der Wiedergabeparametereinstellungen durch den Speicher der Tonwiedergabevorrichtung berücksichtigt werden. Alternativ zu einer solchen manuellen Eingabe derselben Hörszenarioinformation in beide Tonwiedergabevorrichtungen wäre es auch möglich, dass die beiden Tonwiedergabevorrichtungen während der Durchführung der Hörszenario-Simulation oder danach bezüglich der Hörszenarioinformation miteinander kommunizieren.

Gemäß weiteren Ausführungsbeispielen kann vorgesehen sein, dass die Tonwiedergabevorrichtung eine Normalbetrieb-Szenarioschnittstelle, eine Speicherzugriffeinheit und eine Wiedergabeparametereinstellungsaufbereitung umfasst. Die Normalbetrieb-Szenarioschnittstelle ist konfiguriert, eine zweite Hörszenarioinformation zu einem realen Hörszenario zu empfangen. Der Hörer ist diesem realen Hörszenario zu einem Zeitpunkt während eines Normalbetriebs der Tonwiedergabevorrichtung ausgesetzt. Die Speicherzugriffeinheit ist konfiguriert zum Abfragen des Speichers mit der zweiten Hörszenarioinformation und zum Bereitstellen zumindest einer bereitgestellten Wiedergabeparametereinstellung. Die Hörszenarioinformation, die mit Bezug auf die bereitgestellte Wiedergabeparametereinstellung gespeichert wurde, ist hinreichend ähnlich oder identisch zu der zweiten Hörszenarioinformation. Die Wiedergabeparametereinstellungsaufbereitung ist konfiguriert, auf der Basis der zumindest einen bereitgestellten Wiedergabeparametereinstellung eine zweite Wiedergabeparametereinstellung zum Modifizieren eines Nutzsignals während des Normalbetriebs zu ermitteln und für den Signalmodifizierer bereitzustellen.

Die Tonwiedergabevorrichtung kann einen Betriebsartenwähler umfassen, der konfiguriert ist, die Tonwiedergabevorrichtung in eine Lernbetriebsart oder eine Normalbetriebsart zu schalten. Während der Lernbetriebsart werden benutzerangepasste Wiedergabeparametereinstellungen in Bezug auf währenddessen (d.h. zeitgleich zu der Anpassung der Wiedergabeparametereinstellungen durch den Benutzer) vorliegende Hörszenarioinformationen gespeichert. Während der Normalbetriebsart werden zuvor gespeicherte Wiedergabeparametereinstellungen durch den Signalmodifizierer auf ein Nutzsignal angewendet, das in der Normalbetriebsart wiedergegeben werden soll, wenn eine hinreichende Ähnlichkeit oder Identität zwischen der Hörszenarioinformation und der zweiten Hörszenarioinformation vorliegt. Dabei wurde die Hörszenarioinformation gemeinsam und mit Bezug zu den zuvor gespeicherten Wiedergabeparametereinstellungen gespeichert. Die zweite Hörszenarioinformation liegt zu einem gegebenen Zeitpunkt während der Normalbetriebsart vor und beschreibt ein zu diesem Zeitpunkt vorliegendes Hörszenario.

Die Tonwiedergabevorrichtung kann einen Schallsignaleingang für ein Umgebungsgeräuschsignal und einen Schallsignalanalysierer umfassen, der konfiguriert ist, die Hörzsenarioinformation auf der Grundlage des Umgebungsgeräuschsignals zu bestimmen. Der Schallsignaleingang (z.B. ein Mikrofon mit Analog-Digital-Wandler) kann neben dem Umgebungsgeräuschsignal auch andere Signale empfangen, insbesondere das Nutzsignal. Durch geeignete Maßnahmen kann das Umgebungsgeräuschsignal von den übrigen Signalen getrennt werden. Insbesondere kann das Nutzsignal meist von dem empfangenen Signal subtrahiert werden, da das Nutzsignal meistens bekannt ist. Bei einer Wiedergabe in Räumen (z.B. Auto) kommt typischerweise noch eine nicht bekannte Übertragungsfunktion des Raums hinzu (z.B. Nachhall), so dass sich das über einen Lautsprecher o.ä. abgestrahlte Nutzsignal von dem am Schallsignaleingang empfangenen Nutzsignal unterscheidet. Dies führt dazu, dass das am Schallsignaleingang empfangene Nutzsignal typischerweise nur näherungsweise aus dem bekannten Nutzsignal bestimmt werden kann, was jedoch in vielen Anwendungsfällen bereits ausreichen kann. Der Schallsignalanalysierer kann Signalmerkmale des aufgenommenen Umgebungsgeräuschsignals bestimmen, z.B. ein Frequenzspektrum. Die ermittelten Signalmerkmale können verwendet werden, um den Speicher abzufragen und auf diese Weise Datensätze zu ermitteln, die ähnliche Signalmerkmale aufweisen. Diese Datensätze können herangezogen werden, um Wiedergabeparametereinstellungen zu ermitteln, die gut zu dem aktuellen Hörszenario passen.

Die Tonwiedergabevorrichtung kann auch eine Ausgabeschnittstelle umfassen, die konfiguriert ist, Datensätze an einen externen Kommunikationspartner zu übermitteln. Auf diese Weise können die einmal ermittelten individuellen Präferenzen des Hörers an weitere Tonwiedergabevorrichtungen übermittelt werden, ohne dass der Hörer erneut eine Simulation durchführen muss.

Weitere Ausführungsbeispiele der offenbarten Lehre betreffen ein Kraftfahrzeugaudiosystem, eine Schnittstelle, ein Audiosystem, eine Datenstruktur, ein Verfahren und ein Computerprogramm.

Gemäß der offenbarten Lehre erfolgt eine Anpassung von Klangeigenschaften bzw. Wiedergabeparametem für situationsabhängige Hörumgebungen durch eine Simulation und/oder gegebenenfalls auch durch eine Externalisierung. Eine mögliche Anwendung der offenbarten Lehre ist wie folgt: Mit Hilfe eines externen Geräts (z.B. Smartphone mit Kopfhörern) oder auch durch Simulation der Fahrgeräusche über das Soundsystem eines Fahrzeugs werden die akustischen Bedingungen, wie sie im tatsächlichen Fahrbetrieb herrschen, realistisch simuliert. Dabei stellen die simulierten Bedingungen eine große Bandbreite der praktisch vorkommenden Situationen dar, wobei typischerweise gleichzeitig eine möglichst geringe Anzahl von Simulationen durchgeführt wird. Der Nutzer stellt für jede simulierte Situation (also insbesondere unterschiedliche Fahrsituationen) die Klangpräferenzen (z.B. Frequenzgewichtung) am externen Gerät oder über eine Multimedia-Einheit des Fahrzeugs für sich optimal ein. Über eine Schnittstelle werden die so erhaltenen Einstellungen vom externen Gerät an das Soundsystem des Fahrzeugs übermittelt bzw. direkt vom Soundsystem übernommen, welches dann z.B. durch Interpolation der simulierten Situationen für jede reale Fahrsituation die optimalen Klangeinstellungen für den Nutzer bereitstellt. Hierfür muss während der Fahrt die Fahrsituation ermittelt werden, was z.B. durch Abgreifen von Fahrgeschwindigkeit und Motordrehzahl über die Bordelektronik oder durch direkte akustische Analyse geschieht.

Die offenbarte technische Lehre ermöglicht eine Vereinfachung der Einstellung von Klangpräferenz im Automobil bzw. für Audiosystem des Automobils, so dass manuelles Nachregeln im Fahrbetrieb vermieden werden kann. Dies führt zu einer Erhöhung der Sicherheit, da während der Fahrt keine Einstellung von komplexen Wiedergabeparametern vorgenommen werden muss. Bei Simulation innerhalb des (stehenden) Automobils bzw. Fahrzeugs hat man die notwendige Ruhe für die Einstellung, weil die Systeme heute sehr viele und damit kaum zu bedienende Menüs haben. Bei der Einstellung an einem externen Gerät liegt der darüber hinaus zusätzliche Vorteil darin, dass die Bedienschnittstellen dem Nutzer vertrauter sind (z.B. einheitliche Oberflächen, Bedienkonzepte und Interaktionsabläufe innerhalb eines Betriebssystems) als die Menüführung des einzelnen Multimediageräts im Automobil.

### Kurze Beschreibung der Figuren

Ausführungsbeispiele der offenbarten technischen Lehre werden nachfolgend unter Bezugnahme auf beiliegende Zeichnungen näher erläutert.
Fig. 1 zeigt ein schematisches Blockschaltbild einer Tonwiedergabevorrichtung gemäß einem Ausführungsbeispiel der offenbarten technischen Lehre;
Fig. 2 zeigt ein schematisches Blockschaltbild einer Tonwiedergabevorrichtung gemäß einem anderen Ausführungsbeispiel der offenbarten technischen Lehre;
Fig. 3 zeigt schematische Frequenzspektren eines originalen Nutzsignals, eines Störgeräuschs in einer ersten Hörsituation und des Nutzsignals nach erfolgter Modifizierung gemäß einer ersten Wiedergabeparametereinstellung;
Fig. 4 zeigt schematische Frequenzspektren eines originalen Nutzsignals, eines Störgeräusch in einer zweiten Hörsituation und des Nutzsignals nach erfolgter Modifizierung gemäß einer zweiten Wiedergabeparametereinstellung;
Fig. 5 stellt auf schematische Weise einen Merkmalsraum von Hörszenariomerkmalen mit einigen gespeicherten Datensätzen dar, die jeweils eine Hörszenarioinfonnation und eine mit Bezug dazu gespeicherte Wiedergabeparametereinstellung umfassen;
Fig. 6 zeigt ein schematisches Blockschaltbild einer Tonwiedergabevorrichtung gemäß einem weiteren Ausführungsbeispiel der offenbarten technischen Lehre;
Fig. 7 veranschaulicht eine Interaktion zwischen einem Nutzer oder Hörer, einer ersten Tonwiedergabevorrichtung und einer zweiten Tonwiedergabevorrichtung; und
Fig. 8 zeigt ein schematisches Flussdiagramm eines Verfahrens zum Einlernen von benutzerdefinierten und Hörszenario-abhängigen Wiedergabeparametern für eine Tonwiedergabevorrichtung.

Dabei werden in der vorliegenden Anmeldung die gleichen Bezugszeichen oder ähnliche Bezugszeichen für Objekte und Funktionseinheiten verwendet, die gleiche oder ähnliche funktionelle Eigenschaften aufweisen.

### Detaillierte Beschreibung

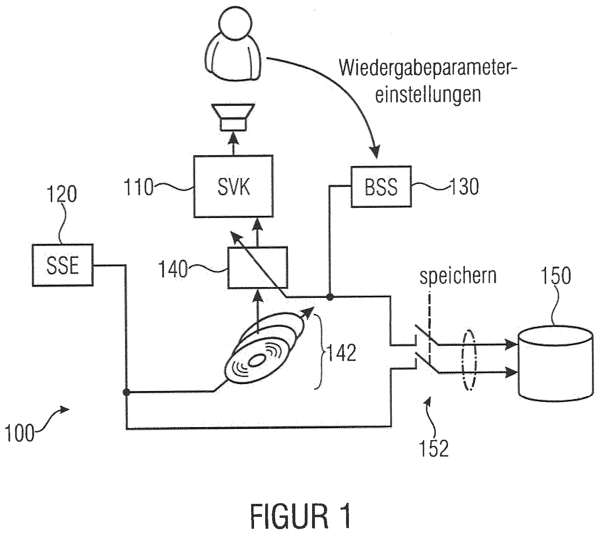

Fig. 1 zeigt ein schematisches Blockschaltbild einer Tonwiedergabevorrichtung 100 gemäß einem möglichen Ausführungsbeispiel der hierin offenbarten technischen Lehre. Die Tonwiedergabevorrichtung umfasst eine Signalverarbeitungskette 110 (SVK), eine Simulationsszenario-Einrichtung 120 (SSE), eine Benutzerschnittstelle 130 (BSS), einen Signalmodifizierer 140 und einen Speicher 150. Ein Eingang der Signalverarbeitungskette 110 ist mit dem Signalmodifizierer 140 verbunden. Alternativ kann der Signalmodifizierer 140 auch Teil der Signalverarbeitungskette 110 sein oder mit einem Ausgang der Signalverarbeitungskette 110 verbunden sein. Ein Ausgang der Signalverarbeitungskette 110 ist mit einem Lautsprecher verbunden, über den ein Nutzsignal für einen Hörer ausgegeben werden kann. Das Nutzsignal wird aus einer Vielzahl von Nutzsignalen 142 ausgewählt, die auf Speichermedien gespeichert sind. In Fig. 1 sind die Speichermedien zur Veranschaulichung als Compact Discs dargestellt, wobei jedoch auch andere Speichermedien oder Signalquellen zum Einsatz kommen können (z.B. Radioübertragung, Audiodateien, Mobiltelefonschnittstelle, etc.).

Die Simulationsszenario-Einrichtung 120 kommt zum Einsatz, wenn sich die Tonwiedergabevorrichtung 100 in einer Lernbetriebsart befindet. Der Nutzer kann über eine entsprechende Benutzereingabe z.B. über die Benutzerschnittstelle 130 die Tonwiedergabevorrichtung 100 in die Lernbetriebsart versetzen. Während der Lernbetriebsart wird von der Simulationsszenario-Einrichtung 120 zumindest ein simuliertes Hörszenario abgearbeitet. In der Regel wird während der Lernbetriebsart eine Vielzahl von Hörszenarien abgearbeitet. Jedem simulierten Hörszenario ist eine Hörszenarioinformation zugeordnet, die repräsentative Eigenschaften des Hörszenarios beschreibt. Bei dem in Fig. 1 gezeigten Ausführungsbeispiel steuert die Simulationsszenario-Einrichtung 120 die Wahl des Nutzsignals aus der Vielzahl der Nutzsignale 142. Dieses Auswählen eines speziellen Nutzsignals kann auf einer Nutzsignalart des ausgewählten Nutzsignals beruhen, die mit einer Hörszenario-Nutzsignalart übereinstimmt oder dieser nahekommt, die in dem aktuell simulierten Hörszenario definiert ist. Alternativ kann das Nutzsignal, das im Rahmen des Hörszenarios wiedergegeben werden soll, auch gemeinsam mit den Hörszenarioinformationen gespeichert werden, z.B. als digitale Audiodatei.

Das ausgewählte Nutzsignal wird über die Signalverarbeitungskette 110 an den Hörer ausgegeben. Der Hörer oder der Benutzer (meistens dieselbe Person) stellt über die Benutzerschnittstelle 130 die Wiedergabeparameter so ein, dass die Wiedergabe des Nutzsignals den individuellen Präferenzen des Benutzers entspricht. Die Benutzerschnittstelle 130 gibt die Wiedergabeparametereinstellung an den Signalmodifizierer 140 weiter, welcher die Wiedergabe des Nutzsignals entsprechend anpasst. Auf diese Weise kann der Hörer Einfluss auf die Lautstärke, Equalizereinstellungen und eventuelle weitere Wiedergabeparameter nehmen. Wenn der Hörer mit den vorgenommenen Einstellungen zufrieden ist, kann er die Tonwiedergabevorrichtung veranlassen, die Wiedergabeparameter zusammen mit der aktuellen Hörszenarioinformation zu speichern. Dies ist in Fig. 1 zur Veranschaulichung schematisch durch einen Doppelschalter 152 dargestellt, der einen Ausgang der Benutzerschnittstelle 130 sowie einen Ausgang der Simulationsszenario-Einrichtung 120 mit dem Speicher 150 verbindet, wenn der Benutzer einen Befehl zum Speichern der vorgenommenen Einstellungen in Bezug zu dem aktuellen Hörszenario gibt. Bei vielen Tonwiedergabevorrichtungen werden die vorgenommenen Wiedergabeparametereinstellungen und die aktuelle Hörszenarioinformation während der Laufzeit typischerweise als Variablen in einem Arbeitsspeichers eines Mikroprozessors oder Mikrocontrollers zwischengespeichert.

Wenn der Benutzer den Befehl zum Speichern gibt, so werden die Werte dieser Variablen mit Bezug zueinander beispielsweise in den nichtflüchtigen Speicher 150 kopiert bzw. geschrieben.

Die Entscheidung, welche Hörszenarien die Simulationsszenario-Einrichtung 120 in welcher Reihenfolge abarbeitet, kann entweder vom Benutzer über die Benutzerschnittstelle 130 oder eine andere Schnittstelle (nicht gezeigt) eingegeben werden. Eine andere Möglichkeit besteht darin, dass die Simulationsszenario-Einrichtung 120 eine vorbestimmte Reihenfolge unterschiedlicher Hörszenarien abarbeitet, wenn die Lernbetriebsart gestartet wird.

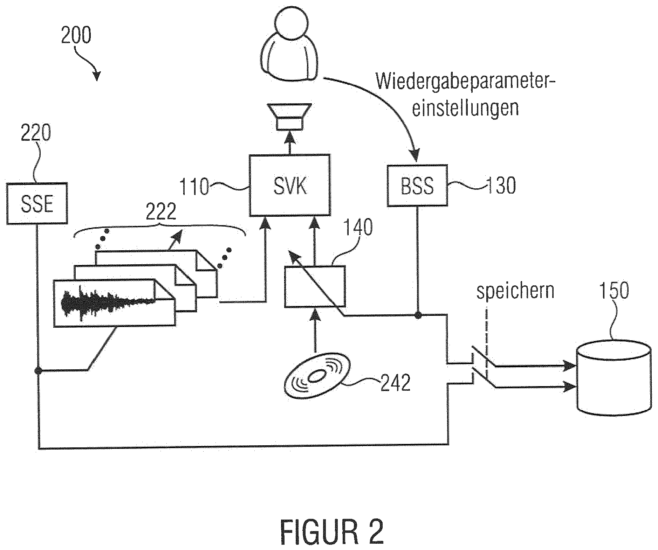

Fig. 2 zeigt ein schematisches Blockschaltbild einer Tonwiedergabevorrichtung 200 gemäß einem anderen möglichen Ausführungsbeispiel der offenbarten Lehre. Im Unterschied zum vorigen Ausführungsbeispiel bezieht sich ein Hörszenario bei dem Ausführungsbeispiel nach Fig. 2 nicht auf das Nutzsignal sondern auf Umgebungs- oder Störgeräusche. Das Nutzsignal stammt von einer Signalquelle 242 und wird über den Signalmodifizierer 140 und die Signalverarbeitungskette 110 an den Hörer ausgegeben.

Parallel zu dem Nutzsignal kann ein Geräuschsignal über die Signalverarbeitungskette 110 an den Hörer ausgegeben werden. Das Geräuschsignal kann z.B. aus einer Sammlung von Geräuschsignalen 222 stammen. Die Geräuschsignal der Sammlung 222 können z.B. in Audiodateien gespeichert sein. Die Simulationsszenario-Einrichtung 220 ist konfiguriert, ein Geräuschsignal aus der Sammlung von Geräuschsignalen 222 auszuwählen, das einem Hörszenario zugeordnet ist, welches gegenwärtig im Rahmen einer Simulation berücksichtigt werden soll. Da das Geräuschsignal gleichzeitig mit dem Nutzsignal ausgegeben wird, kommt es zu Verdeckungs- oder Maskierungseffekten zwischen beiden Signalen. Der Wunsch einer Vielzahl von Hörern ist, dass das Nutzsignal zwar klar und deutlich gegenüber dem Geräuschsignal wahrnehmbar ist, gleichzeitig jedoch nicht übermäßig laut oder unnatürlich wiedergegeben wird. Dieser Wunsch kann für das Nutzsignal als Ganzes gelten oder aber für einzelne Frequenzbereiche des Nutzsignals. Viele störende Geräuschsignale weisen Frequenzbereiche auf, in denen das Geräuschsignal stärker ist, als in anderen Frequenzbereichen. Dies eröffnet die Möglichkeit, das Nutzsignal in unterschiedlichen Frequenzbereichen unterschiedlich zu modifizieren, um so für alle Frequenzbereiche den Wunsch des Hörers nach klarer, deutlicher, aber nicht zu lauter oder zu unnatürlicher Wiedergabe des Nutzsignals zu erfüllen.

In der Lernbetriebsart der Tonwiedergabevorrichtung 200 wird dem Hörer also ein kombiniertes Signal vorgespielt, das das Nutzsignal und das Geräuschsignal umfasst, wobei das Geräuschsignal dem aktuellen Hörszenario zugeordnet ist. Konkret kann dies bedeuten, dass das Hörszenario eine reale Hörsituation simuliert, in der sich der Hörer der Tonwiedergabevorrichtung 200 befinden kann. Ein Beispiel ist, dass die Tonwiedergabevorrichtung und der Hörer sich in einem Fahrzeug befinden, das unterschiedliche Fortbewegungszustände (Stadtverkehr, Landstraße, Autobahn, etc.) einnehmen kann. Ein Hörszenario bildet den Einfluss eines bestimmten Fortbewegungszustands des Fahrzeugs hinsichtlich der dabei entstehenden Geräusche ab. Der Hörer oder Nutzer kann die Wiedergabeparameter für das Nutzsignal über die Benutzerschnittstelle 130 einstellen, bis er eine Wiedergabeparametereinstellung gefunden hat, die er präferiert. Auf diese Weise kann der Hörer für ein gegebenes Hörszenario genau den für ihn angenehmen Kompromiss zwischen deutlichem Abheben des Nutzsignals vom Geräuschsignal und einer moderaten Lautstärke des Nutzsignals finden.

Wie bei dem in Fig. 1 gezeigten Ausführungsbeispiel können die vorgenommenen Wiedergabeparametereinstellungen in Bezug auf die Hörszenarioinformation infolge einer entsprechenden Benutzereingabe in dem Speicher 150 gespeichert werden.

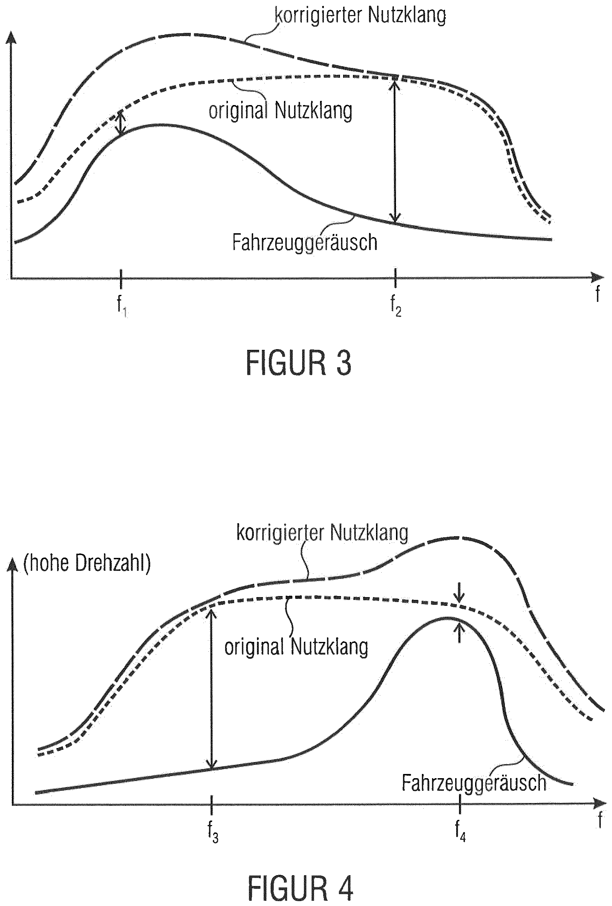

Fig. 3 zeigt schematische Frequenzspektren eines originalen Nutzsignals, eines Störgeräuschs in einer ersten Hörsituation und des Nutzsignals nach erfolgter Modifizierung gemäß einer ersten Wiedergabeparametereinstellung. Das Spektrum des originalen Nutzsignals hat den in Fig. 3 gezeigten Verlauf, der als Beispiel angenommen werden soll. Für die Zwecke der Erklärung wird angenommen, dass es sich bei der ersten Hörsituation um das von einem Kraftfahrzeug erzeugte Geräusch in einem Fahrzeuginnenraum des Kraftfahrzeugs handelt, während das Kraftfahrzeug mit relativ niedriger Drehzahl fährt. Ein Anteil des Fahrzeuggeräuschs entspricht dem Motorgeräusch. Bei niedriger Drehzahl weist das Motorgeräusch hauptsächlich Frequenzanteile bei niedrigen Frequenzen auf, was in Fig. 3 durch ein Maximum des Frequenzspektrums des Fahrzeuggeräuschs bei niedrigen Frequenzen dargestellt ist.

Wie in Fig. 3 zu sehen ist der Pegelabstand zwischen dem originalen Nutzsignal und dem Fahrzeuggeräusch bei einer relativ niedrigen Frequenz f₁ relativ gering. Bei einer höheren Frequenz f₂ ist der Pegelabstand dagegen größer. Der Hörer kann Frequenzanteile des Nutzsignals bei der Frequenz f₁ nur schlecht von dem Geräuschsignal unterscheiden. Frequenzanteile des Nutzsignals, die in der Nähe der Frequenz f₂ liegen, sind dagegen ausreichend stark gegenüber dem Geräuschsignal, so dass der Hörer in diesem Frequenzbereich typischerweise keine Probleme haben sollte, das Nutzsignal klar und deutlich wahrzunehmen.

Um das Nutzsignal im gesamten interessierenden Frequenzspektrum ausreichend klar wahrnehmen zu können, kann der Hörer eine Korrektur oder Modifizierung des originalen Nutzsignals vornehmen. Das Frequenzspektrum des auf diese Weise korrigierten oder modifizierten Nutzsignals ist in Fig. 3 als gestrichelte Linie dargestellt. Um die Korrektur des Nutzsignals vornehmen zu können, muss der Hörer bei herkömmlichen Tonwiedergabevorrichtungen die Wiedergabeparameter wie Lautstärke und Equalizereinstellungen während des Vorliegens der ersten realen Hörsituation, also während das Kraftfahrzeug fährt, ändern.

Fig. 4 zeigt zum Vergleich eine ähnliche Darstellung wie Fig. 3, allerdings bei einer zweiten realen Hörsituation, die einem Fortbewegungszustand bei höherer Motordrehzahl des Kraftfahrzeugs entspricht. Das Frequenzspektrum des Fahrzeuggeräuschs weist nun ein Maximum bei einer relativ hohen Frequenz f₄ auf, während es bei einer relativ niedrigen Frequenz f₃ schwach ist. Die Korrektur des originalen Nutzsignals sieht nun so aus, dass das Nutzsignal in einem Frequenzbereich angehoben wird, der um die Frequenz f₄ liegt. Auf diese Weise kann wieder ein relativ ausgewogener Pegelabstand zwischen dem Nutzsignal und dem Geräuschsignal hergestellt werden.

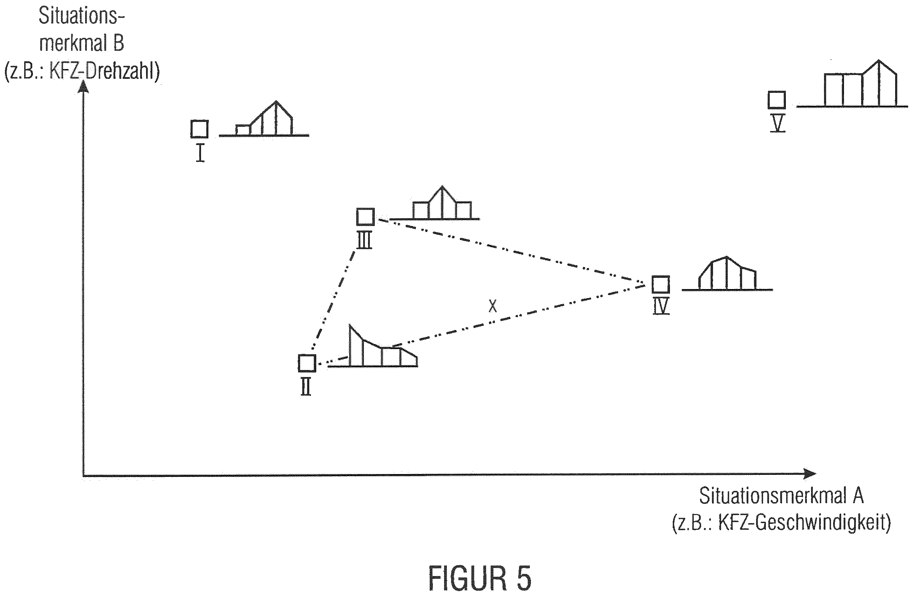

Fig. 5 veranschaulicht einen Merkmalsraum, in dem fünf gespeicherte Datensätze grafisch dargestellt sind. Der Merkmalsraum ist in dem in Fig. 5 dargestellten Beispiel zweidimensional, könnte aber auch eine unterschiedliche Anzahl von Dimensionen haben. Eine erste Dimension ist entlang der Abszisse aufgetragen und kann z.B. einer Geschwindigkeit eines Kraftfahrzeugs entsprechen. Eine zweite Dimension ist entlang der Ordinate aufgetragen und kann z.B. einer Drehzahl des Kraftfahrzeugs entsprechen. Die Dimensionen können auch als Situationsmerkmale bezeichnet werden. Jeder Datensatz umfasst bei dem in Fig. 5 dargestellten Beispiel einen Satz von Situationsmerkmalen und einen Satz von Wiedergabeparametern. Die Situationsmerkmale dienen zur Identifikation des Datensatzes. Alternativ kann ein Datensatz auch eine andere Struktur oder einen anderen Inhalt haben. Zum Beispiel kann der Datensatz anstelle der Situationsmerkmale einen Identifikator für eine bestimmte Kombination von Situationsmerkmalen umfassen.

Jeder der fünf dargestellten Datensätze I, II, III, IV und V umfasst bei dem in Fig. 5 dargestellten Beispiel eine bestimmte, eindeutige Kombination von Situationsmerkmalen. So ist der Datensatz I einer hohen Drehzahl bei niedriger Geschwindigkeit zugeordnet, was einer Situation entspricht, die beim Fahren in niedrigen Gängen, z.B. an starken Steigungen, vorkommt. Der Datensatz II ist dagegen einer niedrigen Drehzahl und einer niedrigen Geschwindigkeit zugeordnet, was z.B. einer Fahrsituation im Stadtverkehr entspricht. Weiterhin umfasst jeder der fünf Datensätze eine bestimmte Equalizereinstellung, die in Fig. 5 schematisch dargestellt sind. Die im Datensatz I gespeicherte Equalizereinstellung hebt das Nutzsignal in einem hohen Frequenzbereich etwas an. Die Equalizereinstellung von Datensatz II hebt das Nutzsignal in einem niedrigen Frequenzbereich an. Die fünf Datensätze I bis V können während eines Lernbetriebs einer Tonwiedergabevorrichtung gespeichert worden sein, in dem das jeweilige Fahrzeuggeräusch im Rahmen der Simulation des jeweiligen Hörszenarios gemeinsam mit dem Nutzsignal wiedergegeben wurde.

Während eines Normalbetriebs der Tonwiedergabevorrichtung oder auch einer anderen Tonwiedergabevorrichtung, die Zugriff auf die Datensätze I bis V hat, kann eine Fahrsituation des Kraftfahrzeugs auftreten, die in Fig. 5 mit einem Kreuz gekennzeichnet ist. Um eine Equalizereinstellung zu bestimmen, die die Präferenzen des Hörers am besten widerspiegelt, können die k am nächsten liegenden Datensätze mittels einer Metrik ermittelt werden. Im dargestellten Beispiel sind dies die Datensätze II, III und IV mit k=3. Auf der Grundlage der ermittelten Datensätzen kann eine Wiedergabeparametereinstellung ermittelt werden, mit der während des Normalbetriebs die Wiedergabe eines Nutzsignals modifiziert werden kann. Für die Ermittlung der genannten Wiedergabeparametereinstellung kommen verschiedene Möglichkeiten in Betracht, wie eine Mittelung der Equalizereinstellungen der Datensätze II bis IV, eine Interpolation oder eine andere Funktion. Auf diese Weise können mit einer begrenzten Anzahl von Datensätzen auch Wiedergabeparametereinstellungen für dazwischenliegende Hörsituationen ermittelt werden. Bei der Ermittlung der Wiedergabeparametereinstellungen können psychoakustische Erkenntnisse berücksichtigt werden.

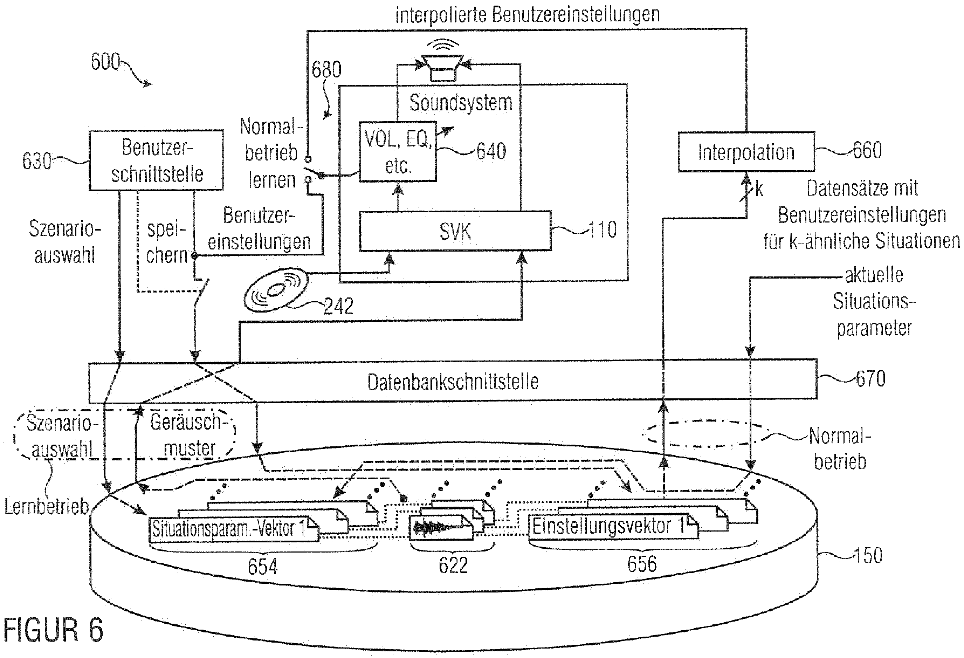

Fig. 6 zeigt ein schematisches Blockdiagramm einer Tonwiedergabevorrichtung 600 gemäß einem weiteren möglichen Ausführungsbeispiel der offenbarten technischen Lehre. Von einer Nutzsignalquelle 242 wird ein Nutzsignal bereitgestellt, das über die Signalverarbeitungskette 110 und den Signalmodifizierer 640 (hier der Signalverarbeitungskette nachgeschaltet) ausgegeben wird. Die Signalverarbeitungskette 110 und der Signalmodifizierer 640 sind Teil eines Soundsystems oder Audiosystems. Über einen Schalter 680 kann die Tonwiedergabevorrichtung 600 in einen Lembetrieb oder einen Normalbetrieb geschaltet werden. In der Lernbetriebsart werden Wiedergabeparametereinstellungen, die von dem Signalmodifizierer 640 auf das Nutzsignal angewendet werden, von der Benutzerschnittstelle 630 bereitgestellt. Während der Lernbetriebsart wird auch eine Szenarioauswahl von der Benutzerschnittstelle 630 an eine Datenbankschnittstelle 670 übermittelt. Die Datenbankschnittstelle 670 fragt eine Datenbank 150 ab nach passenden Datensätzen. Passende Datensätze sind Datensätze, bei denen ein Situationsparametervektor 654 mit der Szenarioauswahl übereinstimmt. Alternativ kann die Abfrage der Datenbank 150 auch mittels eines Identifikators eines Datensatzes erfolgen. Als Antwort auf die Abfrage stellt die Datenbank 150 ein Geräuschmuster aus einer Sammlung von Geräuschmustern 622 bereit, wobei das bereitgestellte Geräuschmuster dem angeforderten Datensatz zugeordnet ist. Das Geräuschmuster wird über die Signalverarbeitungskette 110 an den Hörer ausgegeben, ohne jedoch den Signalmodifizierer 640 zu durchlaufen. Über die Benutzerschnittstelle 630 nimmt der Hörer Änderungen an den Wiedergabeparametern für die Wiedergabe des Nutzsignals vor. Wenn dem Hörer die vorgenommenen Wiedergabeparametereinstellungen zusagen, so veranlasst er über die Benutzerschnittstelle 630 die Speicherung dieser Wiedergabeparametereinstellungen als ein Einstellungsvektor 656 in dem entsprechenden Datensatz in der Datenbank 150.

Während des Normalbetriebs der Tonwiedergabevorrichtung 600 empfängt die Tonwiedergabevorrichtung 600 aktuelle Situationsparameter, die z.B. von einem Bordcomputer eines Kraftfahrzeugs über eine Schnittstelle der Tonwiedergabevorrichtung 600 bereitgestellt werden können und Informationen über einen Fortbewegungszustands des Kraftfahrzeugs angeben. Eine andere Möglichkeit besteht darin, dass z.B. ein Mikrofon ein Umgebungsgeräusch aufnimmt und ein Schallsignalanalysierer (nicht gezeigt) daraus aktuelle Werte für Situationsparameter bzw. -merkmale berechnet, z.B. ein Frequenzspektrum eines Geräuschsignals. Die Situationsparameter werden an die Datenbankschnittstelle 670 übergeben, welche die Datenbank 150 mit den darin enthaltenen Informationen abfragt. Typischerweise wird keiner der gespeicherten Datensätze genau den Situationsparametern entsprechen. Es können aber mittels einer Metrik in dem Merkmalsraum typischerweise Datensätze ermittelt werden, die hinreichend ähnlich sind. Die hinreichend ähnlichen Datensätze (Anzahl k) werden an einen Interpolierer 660 übergeben, welcher konfiguriert ist, interpolierte Wiedergabeparametereinstellungen zu erzeugen und für den Signalmodifizierer 640 bereitzustellen.

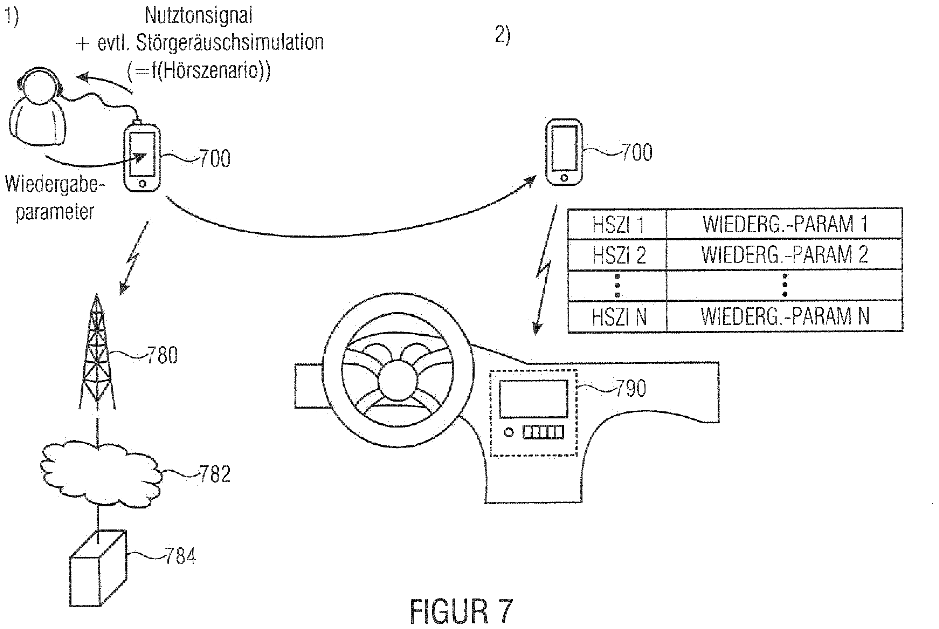

Fig. 7 veranschaulicht eine Interaktion zwischen einem Hörer/Nutzer, einer ersten Tonwiedergabevorrichtung und einer zweiten Tonwiedergabevorrichtung. In einer ersten Phase verwendet der Nutzer die erste Tonwiedergabevorrichtung 700, um ein Hörszenario oder mehrere Hörszenarien zu simulieren. Dazu gibt die erste Tonwiedergabevorrichtung 700 ein Nutzsignal und gegebenenfalls auch ein (Stör-)Geräuschsignal an den Hörer aus. Das Nutzsignal und/oder das Geräuschsignal werden von jeweils einem Hörszenario definiert, sie sind also eine Funktion des Hörszenarios. Das Hörszenario kann auf oder in der Tonwiedergabevorrichtung gespeichert sein oder die Tonwiedergabevorrichtung kann konfiguriert sein, mit einer entfernten Quelle 784 für Hörszenarien zu kommunizieren. In dem in Fig. 7 dargestellten Beispiel kann die Tonwiedergabevorrichtung 700 drahtlos mit einer Mobilfunkstation 780 kommunizieren, die ihrerseits an ein Netzwerk 782 angeschlossen ist. Die entfernte Quelle 784 ist ebenfalls an das Netzwerk 782 angeschlossen und kann z.B. ein Server sein. Die Tonwiedergabevorrichtung 700 kann auf diese Weise Datensätze für Hörszenarien von der entfernten Quelle 784 empfangen. Die Datensätze umfassen typischerweise eine Hörszenarioinformation, mittels der die Tonwiedergabevorrichtung 700 das Hörszenario simulieren kann. Gegebenenfalls kann ein Datensatz auch ein zugehöriges Störgeräusch umfassen, das als digitales Audiosignal vorliegt.

Nachdem der Hörer in der ersten Phase für zumindest ein Hörszenario die Wiedergabeparameter nach seinen individuellen Präferenzen eingestellt und in Bezug auf dieses Hörszenario gespeichert hat, kann die erste Tonwiedergabevorrichtung in einer zweiten Phase dazu genutzt werden, die individuell angepassten Datensätze an die zweite Tonwiedergabevorrichtung 790 zu übermitteln. Jeder Datensatz umfasst die Hörszenarioinformation HSZI und die von dem Nutzer eingestellten Wiedergabeparameter. In dem dargestellten Beispiel werden N Datensätze übermittelt. Die erste Tonwiedergabevorrichtung 700 und die zweite Tonwiedergabevorrichtung 790 verfügen jeweils über eine Schnittstelle, die die Kommunikation der zwei Tonwiedergabevorrichtungen 700 und 790 sowie die Übermittlung der Datensätze ermöglicht. Die Schnittstelle kann z.B. eine drahtlose Schnittstelle wie WLAN oder Bluetooth, eine kabelgebundene Schnittstelle wie USB (Universal Serial Bus), oder eine Infrarotschnittstelle umfassen. Die Schnittstelle ist konfiguriert, die zu sendenden oder empfangenen Datensätze wie vorgesehen zu verarbeiten. Dies bedeutet, dass die Schnittstell mit dem Speicher 150 interagiert, um die Datensätze ordnungsgemäß aus dem Speicher auszulesen bzw. empfängerseitig ordnungsgemäß abzuspeichern. Aus der Perspektive der ersten Tonwiedergabevorrichtung 700 stellt die zweite Tonwiedergabevorrichtung 790 einen externen Kommunikationspartner dar. Der externe Kommunikationspartner muss aber nicht unbedingt eine weitere Tonwiedergabevorrichtung sein, sondern kann eine beliebige Vorrichtung sein, die eine entsprechende Schnittstelle aufweist. Auf diese Weise können z.B. Datensicherungskopien der Datensätze auf einem Flash-Speicher bzw. einem USB-Stick erstellt werden.

Die zweite Tonwiedergabevorrichtung ist in dem in Fig. 7 gezeigten Beispiel als Audiosystem in einem Kraftfahrzeug dargestellt. Die Hörszenarioinformation kann in diesem Fall z.B. folgende Informationen umfassen, um typischerweise auftretende Hörsituationen nachbilden zu können:
Kraftfahrzeughersteller
Kraftfahrzeugtyp
Antriebsart (Benzin, Diesel, Gas, Hybridantrieb, ...)
Geschwindigkeit
Drehzahl
Reifentyp

Die Fahrzeuggeräusche können für verschiedene Kraftfahrzeugtypen und für unterschiedliche Geschwindigkeiten einmalig aufgenommen werden, um dann einer großen Anzahl von Nutzern zur Verfügung gestellt zu werden. Die Fahrzeuggeräusche werden möglichst derart aufgenommen und abgemischt, damit sich bei Ihrer Wiedergabe an den Hörer z.B. mittels eines Kopfhörers eine realistische Wahrnehmung der echten Fahrzeuggeräusche ergibt. Zu diesem Zweck kann der Hörer aufgefordert werden, eine Lautstärkeeinstellung der Tonwiedergabevorrichtung auf einen vorbestimmten Wert einzustellen. Das Geräuschsignal kann auch aus mehreren Quellen kombiniert werden, z.B. ein erstes Geräuschsignal für das Motorgeräusch, ein zweites Geräuschsignal für ein Reifengeräusch und ein drittes Geräuschsignal für ein Fahrtwindgeräusch. Die Kombination der Geräuschsignale aus mehreren Quellen umfasst dann ein Mischen der Geräuschsignale, wodurch sich das Gesamtgeräusch ergibt.

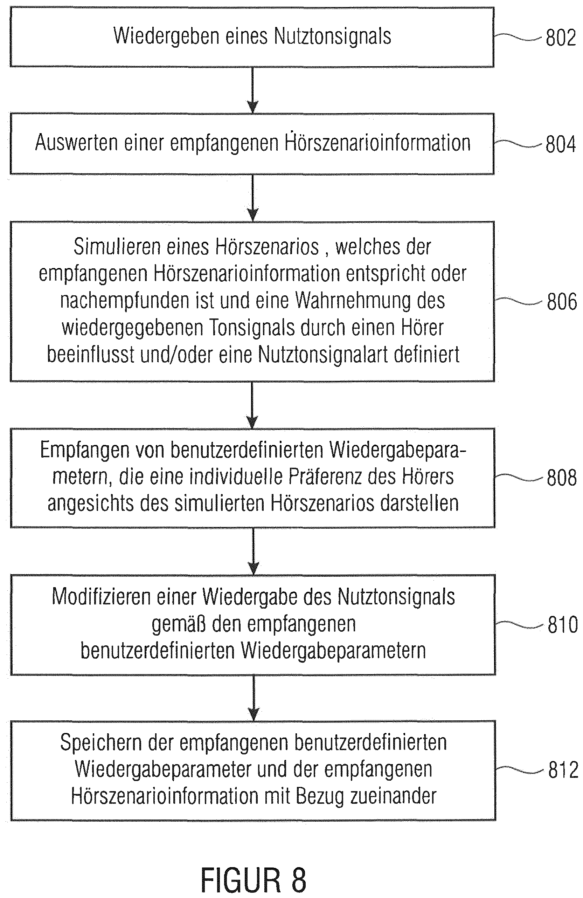

Fig. 8 zeigt ein schematisches Flussdiagramm eines Verfahrens zum Einlernen von benutzerdefinierten und Hörszenario-abhängigen Wiedergabeparametern für eine Tonwiedergabevorrichtung. Im Rahmen einer Aktion 802 wird ein Nutzsignal wiedergegeben. Die Wiedergabe des Nutzsignals kann während der Ausführung der übrigen Aktionen des Verfahrens fortgesetzt werden. Bei 804 wird eine empfangene Hörszenarioinformation ausgewertet. Die Aktionen 802 und 804 können in einer anderen Reihenfolge ablaufen, als in Fig. 8 dargestellt. Somit kann zunächst eine Hörszenarioinformation empfangen und ausgewertet werden. Die Auswertung der Hörszenarioinformation kann Einfluss darauf nehmen, welches Nutzsignal ausgegeben wird. Bei 806 wird ein Hörszenario simuliert, welches der empfangenen Hörszenarioinformation entspricht oder nachempfunden ist. Das simulierte Hörszenario beeinflusst eine Wahrnehmung des wiedergegebenen akustischen Signals durch einen Hörer und/oder definiert eine Nutzsignalart.

Eine weitere Aktion 808, die während des Ablaufs des Verfahrens durchgeführt wird, besteht darin, benutzerdefinierte Wiedergabeparameter zu empfangen, die eine individuelle Präferenz des Hörers angesichts des simulierten Hörszenarios darstellen. Bei 810 wird die Wiedergabe des Nutzsignals gemäß den empfangenen benutzerdefinierten Wiedergabeparametern modifiziert. Schließlich werden die (zuletzt) empfangenen benutzerdefinierten Wiedergabeparameter, während das simulierte Hörszenario aktiv ist, und die empfangene Hörszenarioinformation mit Bezug zu einander gespeichert, wie es durch die Aktion 812 angedeutet ist.

Die hierin offenbarte technische Lehre kann unter anderem bei Audiosystemen und Peripherie in Fahrzeugen angewendet werden. Prinzipiell können alle Kommunikations- oder Soundsysteme die Lehre verwenden, bei denen sich der Hörer in variierenden akustischen Umgebungen aufhält und bei der die Möglichkeit besteht, Klangpräferenzen einzustellen. Bei anderen Anwendungen als für Audiosysteme in Kraftfahrzeugen können andere Situationsmerkmale gewählt werden. Für Zugreisende ist zum Beispiel eine Anpassung der Lautstärke während Lautsprecherdurchsagen interessant: Entweder soll die Lautsprecherdurchsage die Wiedergabe des Nutzsignals nicht stören, weswegen das Nutzsignal entsprechend lauter wiedergegeben wird. Oder der Hörer möchte die Lautsprecheransage hören, da ihm ansonsten wichtige Informationen über den Zugverkehr entgehen könnten. In diesem zweiten Fall würde die individuelle Präferenz des Hörers dahin gehen, dass er die Wiedergabe des Nutzsignals während der Lautsprecheransage leiser macht. Die Entscheidung, wann eine Lautsprecheransage vorliegt, kann von dem weiter oben erwähnten Schallsignalanalysierer vorgenommen werden.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Tonwiedergabevorrichtung (100), umfassend:
eine Signalverarbeitungskette (110), die konfiguriert ist, ein akustisches Nutzsignal (142), das auf einem Speichermedium gespeichert ist, für eine Wiedergabe an einen Hörer aufzubereiten;
eine Simulationsszenario-Einrichtung (120), die konfiguriert ist, eine Hörszenarioinformation zu einem simulierten Hörszenario bereitzustellen, wobei das simulierte Hörszenario eine durch den Hörer erfolgende Wahrnehmung der Wiedergabe des Nutzsignals (142) beeinflusst und/oder eine Nutzsignalart definiert;
eine Benutzerschnittstelle (130), die konfiguriert ist, Wiedergabeparametereinstellungen von einem Benutzer zu erfassen, die eine individuelle Präferenz des Hörers angesichts des simulierten Hörszenarios abbilden;
einen Signalmodifizierer (140), der konfiguriert ist, die Wiedergabeparametereinstellungen zu empfangen und die Wiedergabe des Nutzsignals (142) nach Maßgabe der Wiedergabeparametereinstellungen zu modifizieren; und
einen Speicher (150) zum Speichern der Wiedergabeparametereinstellung und der Hörszenarioinformation mit Bezug zueinander;
**dadurch gekennzeichnet, dass** der Signalmodifizierer (140) lediglich die Wiedergabe des Nutzsignals, nicht die Wiedergabe eines Störgeräusches beeinflusst, das im Rahmen des simulierten Hörszenarios gemeinsam mit dem Nutzsignal (142) wiedergegeben wird.

2. Tonwiedergabevorrichtung (100) nach Anspruch 1, wobei die Benutzerschnittstelle (130) konfiguriert ist, die Hörszenarioinformation als Benutzereingabe zu erfassen.

3. Tonwiedergabevorrichtung (100) nach Anspruch 1 oder 2, wobei die Simulationsszenario-Einrichtung (120) zumindest eines umfasst von: einer Funkschnittstelle, einer Infrarotschnittstelle, einer kabelgebundenen Schnittstelle, einer grafischen Benutzeroberfläche, einer sprachbasierten Benutzerschnittstelle (130), einer anfassbaren Benutzerschnittstelle (130) ("tangible user interface") und einer natürlichen Benutzerschnittstelle (130) ("natural user interface - NUI").

4. Tonwiedergabevorrichtung (100) nach einem der Ansprüche 1 bis 3, wobei die Simulationsszenario-Einrichtung (120) konfiguriert ist, das simulierte Hörszenario selbst zu erzeugen.

5. Tonwiedergabevorrichtung (100) nach Anspruch 4, wobei die Simulationsszenario-Einrichtung (120) einen Umgebungsgeräuschsimulator umfasst, der konfiguriert ist, das Störgeräusch auszugeben, das dem simulierten Hörszenario zugeordnet ist.

6. Tonwiedergabevorrichtung (100) nach einem der Ansprüche 1 bis 3, wobei die Signalverarbeitungskette (110) weiterhin konfiguriert ist, ein das Störgeräusch für die Wiedergabe an den Hörer aufzubereiten, wobei das Störgeräusch dem Hörszenario zugeordnet ist.

7. Tonwiedergabevorrichtung (100) nach einem der vorhergehenden Ansprüche, weiter umfassend:
eine Nonnalbetrieb-Szenarioschnittstelle, die konfiguriert ist, eine zweite Hörszenarioinformation zu einem realen Hörszenario zu empfangen, welchem der Hörer zu einem Zeitpunkt während eines Normalbetriebs der Tonwiedergabevorrichtung (100) ausgesetzt ist;
eine Speicherzugriffeinheit zum Abfragen des Speichers (150) mit der zweiten Hörszenarioinformation und zum Bereitstellen zumindest einer bereitgestellten Wiedergabeparametereinstellung, deren mit Bezug zueinander gespeicherte Hörszenarioinformation hinreichend ähnlich oder identisch zu der zweiten Hörszenarioinformation ist; und
eine Wiedergabeparametereinstellungsaufbereitung, die konfiguriert ist, auf der Basis der zumindest einen bereitgestellten Wiedergabeparametereinstellung eine zweite Wiedergabeparametereinstellung zum Modifizieren eines Nutzsignals (142) während des Normalbetriebs zu ermitteln und für den Signalmodifizierer (140) bereitzustellen.

8. Tonwiedergabevorrichtung (100) nach Anspruch 7, weiter umfassend einen Betriebsartenwähler, der konfiguriert ist, die Tonwiedergabevorrichtung (100) in eine Lernbetriebsart oder eine Normalbetriebsart zu schalten, wobei während der Lernbetriebsart benutzerangepasste Wiedergabeparametereinstellungen in Bezug auf währenddessen vorliegende Hörszenarioinformationen gespeichert werden, und wobei während der Normalbetriebsart zuvor gespeicherte Wiedergabeparametereinstellungen auf ein in der Normalbetriebsart wiederzugebendes Nutzsignal (142) durch den Signalmodifizierer (140) angewendet werden, wenn eine hinreichende Ähnlichkeit oder Identität zwischen der Hörszenarioinformation, die mit Bezug zu den zuvor gespeicherten Wiedergabeparametereinstellungen gespeichert wurde, und der zweiten Hörszenarioinformation vorliegt, die zu einem aktuellen Zeitpunkt vorliegt und ein aktuelles Hörszenario beschreibt.

9. Tonwiedergabevorrichtung (100) nach einem der vorhergehenden Ansprüche, weiter umfassend:
einen Schallsignaleingang für ein Umgebungsgeräuschsignal;
einen Schallsignalanalysierer, der konfiguriert ist, die Hörszenarioinformation auf der Grundlage des Umgebungsgeräuschsignals zu bestimmen.

10. Tonwiedergabevorrichtung (100) nach einem der vorhergehenden Ansprüche, wobei die Wiedergabeparametereinstellungen zumindest eines umfassen von: Lautstärkeeinstellung, Klangeinstellung, Frequenzgangeinstellung, Equalizer-Einstellung, Kompressionseinstellung, Balance-Einstellung und Fader-Einstellung.

11. Tonwiedergabevorrichtung (100) nach einem der vorhergehenden Ansprüche, weiter umfassend eine Ausgabeschnittstelle, die konfiguriert ist, Datensätze, die die Wiedergabeparametereinstellung und die Hörszenarioinformation umfassen, an einen externen Kommunikationspartner zu übermitteln.

12. Verfahren zum Einlernen von benutzerdefinierten und Hörszenario-abhängigen Wiedergabeparametern für eine Tonwiedergabevorrichtung (100), das Verfahren umfassend:
Wiedergeben eines akustischen Nutzsignals (142), das auf einem Speichermedium gespeichert ist;
Auswerten einer empfangenen Hörszenarioinformation;
Simulieren eines Hörszenarios, welches der empfangenen Hörszenarioinformation entspricht oder nachempfunden ist und eine Wahrnehmung des wiedergegebenen Schallsignals durch einen Hörer beeinflusst und/oder eine Nutzsignalart definiert;
Empfangen von benutzerdefinierten Wiedergabeparametern, die eine individuelle Präferenz des Hörers angesichts des simulierten Hörszenarios darstellen;
Modifizieren einer Wiedergabe des Nutzsignals (142) gemäß den empfangenen benutzerdefinierten Wiedergabeparametern; und
Speichern der empfangenen benutzerdefinierten Wiedergabeparameter und der empfangenen Hörszenarioinformation mit Bezug zueinander;
**dadurch gekennzeichnet, dass** lediglich die Wiedergabe des Nutzsignals, nicht die Wiedergabe eines Störgeräusches beeinflusst wird, das im Rahmen des simulierten Hörszenarios gemeinsam mit dem Nutzsignal (142) wiedergegeben wird.

13. Verfahren nach Anspruch 12, wobei das Simulieren des Hörszenarios die Erzeugung des Störgeräusches umfasst, das typisch für das Hörszenario ist.

14. Verfahren nach Anspruch 12 oder 13, wobei das Auswerten der empfangenen Hörszenarioinformation ein Analysieren des Nutzsignals (142) umfasst.

15. Verfahren nach einem der Ansprüche 12 bis 14, weiter umfassend:
Umschalten von einem Lernbetrieb zu einem Normalbetrieb;
Empfangen einer zweiten Hörszenarioinformation, die einem realen Hörszenario zugeordnet ist, welchem der Hörer zu einem Zeitpunkt während des Normalbetriebs ausgesetzt ist;
Bereitstellen zumindest einer bereitgestellten Wiedergabeparametereinstellung, deren in Bezug dazu gespeicherte Hörszenarioinformation hinreichend ähnlich oder identisch zu der zweiten Hörszenarioinformation ist;
Ermitteln einer zweiten Wiedergabeparametereinstellung auf der Basis der zumindest einen bereitgestellten Wiedergabeparametereinstellung; und
Modifizieren einer Wiedergabe eines zweiten akustischen Nutzsignals (142) gemäß der zweiten Wiedergabeparametereinstellung.

16. Verfahren nach Anspruch 15, wobei das Ermitteln der zweiten Wiedergabeparametereinstellung zumindest eines umfasst von: einer Interpolation, einer Modellauswertung, einer Auswertung eines psychoakustischen Modells und einer Auswertung einer Heuristik.

17. Computerprogramm mit einem Programmcode zur Durchführung des Verfahrens nach einem der Ansprüche 12 bis 16, wenn das Computerprogramm auf einem Computer abläuft, welcher mit einer Tonwiedergabevorrichtung nach einem der Ansprüche 1-11 verbunden ist.

## Claims

1. A sound reproduction device (100) comprising:
a signal processing chain (110) configured to render an acoustic useful signal (142) stored on a storage medium for reproduction to a listener;
simulation scenario means (120) configured to provide auditory scenario information for a simulated auditory scenario, the simulated auditory scenario influencing perception, by the listener, of the reproduction of the useful signal (142) and/or defining a useful signal type;
a user interface (130) configured to detect reproduction parameter settings from a user which represent an individual preference of the listener in view of the simulated auditory scenario;
a signal modifier (140) configured to receive reproduction parameter settings and modify reproduction of the useful signal (142) in dependence on the reproduction parameter settings; and
a storage (150) for storing the reproduction parameter setting and the auditory scenario information relative to one another;
**characterized in that** the signal modifier (140) merely influences the reproduction of the useful signal, not the reproduction of an interference noise that is reproduced together with the useful signal (142) within the simulated auditory scenario.

2. The sound reproduction device (100) in accordance with claim 1, wherein the user interface (130) is configured to detect the auditory scenario information as a user input.

3. The sound reproduction device (100) in accordance with claims 1 or 2, wherein the simulation scenario means (120) comprises at least one of a radio interface, an infrared interface, a wired interface, a graphical user interface, a speech-based user interface (130), a tangible user interface (130) and a natural user interface (130) (NUI).

4. The sound reproduction device (100) in accordance with one of claims 1 to 3, wherein the simulation scenario means (120) is configured to generate the simulated auditory scenario itself.

5. The sound reproduction device (100) in accordance with claim 4, wherein the simulation scenario means (120) comprises an ambient noise simulator configured to output the interference noise associated to the simulated auditory scenario.

6. The sound reproduction device (100) in accordance with one of claims 1 to 3, wherein the signal processing chain (110) is also configured to render the interference noise for reproduction to the listener, the interference noise being associated to the auditory scenario.

7. The sound reproduction device (100) in accordance with one of the preceding claims, further comprising:
a normal operation scenario interface configured to receive second auditory scenario information for a real auditory scenario which the listener is exposed to at a time during normal operation of the sound reproduction device (100);
a storage access unit for polling the storage (150) with the second auditory scenario information and for providing at least one reproduction parameter setting provided the auditory scenario information of which stored relative to one another are sufficiently similar or identical to the second auditory scenario information; and
a reproduction parameter setting rendering configured to establish and provide to the signal modifier (140), on the basis of the at least one reproduction parameter setting provided, a second reproduction parameter setting for modifying a useful signal (142) during normal operation.

8. The sound reproduction device (100) in accordance with claim 7, further comprising an operation type selector configured to switch the sound reproduction device (100) to a learning type of operation or a normal type of operation, wherein, during the learning type of operation, user-adjusted reproduction parameter settings with regard to auditory scenario information present in the meantime are stored and, during the normal type of operation, reproduction parameter settings stored before are applied to a useful signal (142) to be reproduced in the normal type of operation by the signal modifier (140) when there is sufficient similarity or identity between the auditory scenario information having been stored with regard to the reproduction parameter settings stored before and the second auditory scenario information present at a current time and describing a current auditory scenario.

9. The sound reproduction device (100) in accordance with one of the preceding claims, further comprising:
a sound signal input for an ambient noise signal;
a sound signal analyzer configured to determine the auditory scenario information on the basis of the ambient noise signal.

10. The sound reproduction device (100) in accordance with one of the preceding claims, wherein the reproduction parameter settings comprise at least one of a volume setting, sound setting, frequency response setting, equalizer setting, compression setting, balance setting and fader setting.

11. The sound reproduction device (100) in accordance with one of the preceding claims, further comprising an output interface configured to transfer data sets which comprise the reproduction parameter setting and the auditory scenario information to an external communication partner.

12. A method for training user-defined and auditory scenario-dependent reproduction parameters for a sound reproduction device (100), comprising:
reproducing an acoustic useful signal (142) stored on a storage medium;
evaluating auditory scenario information received;
simulating an auditory scenario which corresponds to the auditory scenario information received or is adapted therefrom and influences perception of the sound signal reproduced by a listener and/or defines a useful signal type;
receiving user-defined reproduction parameters which represent an individual preference of the listener in view of the simulated auditory scenario;
modifying reproduction of the useful signal (142) in accordance with the user-defined reproduction parameters received; and
storing the user-defined reproduction parameters received and the auditory scenario information received relative to one another;
**characterized in that** merely the reproduction of the useful signal is influenced, not the reproduction of an interference noise that is reproduced together with the useful signal (142) within the simulated auditory scenario.

13. The method in accordance with claim 12, wherein simulating the auditory scenario comprises generating the interference noise which is typical of the auditory scenario.

14. The method in accordance with one of claims 12 or 13, wherein evaluating the auditory scenario information received comprises analyzing the useful signal (142).

15. The method in accordance with one of claims 12 to 14, further comprising:
switching from learning operation to normal operation;
receiving second auditory scenario information associated to a real auditory scenario which the listener is exposed to at a time during normal operation;
providing at least one reproduction parameter setting provided the auditory scenario information of which stored relating thereto is sufficiently similar or identical to the second auditory scenario information;
establishing a second reproduction parameter setting on the basis of the at least one reproduction parameter setting provided; and
modifying reproduction of a second acoustic useful signal (142) in accordance with the second reproduction parameter setting.

16. The method in accordance with claim 15, wherein establishing the second reproduction parameter setting comprises at least one of an interpolation, model evaluation, evaluation of a psycho-acoustic model and heuristics evaluation.

17. A computer program comprising program code for performing the method in accordance with one of claims 12 to 16 when the computer program runs on a computer connected to a sound reproduction device according to one of claims 1 to 11.

## Revendications

1. Dispositif de reproduction de son (100), comprenant:
une chaîne de traitement de signal (110) qui est configurée pour traiter un signal acoustique utile (142) qui est mémorisé sur un support de mémoire, pour une reproduction à un auditeur;
un moyen de scénario de simulation (120) qui est configuré pour mettre à disposition une information de scénario d'écoute relative à un scénario d'écoute simulé, où le scénario d'écoute simulé influence la perception qui a lieu par l'auditeur de la reproduction du signal utile (142) et/ou définit un type de signal utile;
une interface d'utilisateur (130) qui est configurée pour capturer les réglages de paramètres de reproduction d'un utilisateur qui reflètent une préférence individuelle de l'auditeur en ce qui concerne le scénario d'écoute simulé;
un modificateur de signal (140) qui est configuré pour recevoir les réglages de paramètres de reproduction et pour modifier la reproduction du signal utile (142) selon les réglages de paramètres de reproduction; et
une mémoire (150) destinée à mémoriser le réglage de paramètres de reproduction et les informations de scénario d'écoute l'un par rapport aux autres;
**caractérisé par le fait que** le modificateur de signal (140) influence uniquement la reproduction du signal utile, et non pas la reproduction du bruit de fond qui est reproduit ensemble avec le signal utile (142) dans le cadre du scénario d'audition simulé.

2. Dispositif de reproduction de son (100) selon la revendication 1, dans lequel l'interface d'utilisateur (130) est configurée pour capturer les informations de scénario d'écoute comme entrée d'utilisateur.

3. Dispositif de reproduction de son (100) selon la revendication 1 ou 2, dans lequel le moyen de scénario de simulation (120) comprend au moins l'un parmi: une interface radio, une interface infrarouge, une interface filaire, une interface d'utilisateur graphique, une interface d'utilisateur vocale (130), une interface d'utilisateur tangible (130) ("tangible user interface") et une interface d'utilisateur naturelle (130) ("natural user interface - NUI").

4. Dispositif de reproduction de son (100) selon l'une des revendications 1 à 3, dans lequel le moyen de scénario de simulation (120) est configuré pour générer lui-même le scénario d'écoute simulé.

5. Dispositif de reproduction de son (100) selon la revendication 4, dans lequel le moyen de scénario de simulation (120) comporte un simulateur de bruit ambiant qui est configuré pour sortir le bruit de fond qui est associé au scénario d'audition simulé.

6. Dispositif de reproduction de son (100) selon l'une des revendications 1 à 3, dans lequel la chaîne de traitement de signal (110) est par ailleurs configurée pour préparer le bruit de fond pour la reproduction à l'auditeur, dans lequel le bruit de fond est associé au scénario d'écoute.

7. Dispositif de reproduction de son (100) selon l'une des revendications précédentes, comportant par ailleurs:
une interface de scénario de fonctionnement normal qui est configurée pour recevoir une deuxième information de scénario d'écoute relative à un scénario d'écoute réel auquel l'auditeur est exposé à un moment pendant un fonctionnement normal du dispositif de reproduction de son (100);
une unité d'accès à la mémoire destinée à interroger la mémoire (150) par la deuxième information de scénario d'écoute et à mettre à disposition au moins un réglage de paramètres de reproduction préparé dont l'information de scénario d'écoute mémorisée l'une par rapport à l'autre est suffisamment similaire ou identique à la deuxième information de scénario d'écoute; et
une préparation de réglage de paramètres de reproduction qui est configurée pour déterminer, sur base de l'au moins un réglage de paramètres de reproduction préparé, un deuxième réglage de paramètres de reproduction pour modifier un signal utile (142) pendant le fonctionnement normal et pour le mettre à disposition du modificateur de signal (140).

8. Dispositif de reproduction de son (100) selon la revendication 7, comportant par ailleurs un sélecteur de mode de fonctionnement qui est configuré pour commuter le dispositif de reproduction de son (100) à un mode d'apprentissage ou à un mode de fonctionnement normal, dans lequel sont mémorisés, pendant le mode d'apprentissage, les réglages de paramètres de reproduction adaptés par l'utilisateur par rapport aux informations de scénario d'écoute présentes pendant ce dernier, et dans lequel, pendant le mode de fonctionnement normal, les réglages de paramètres de reproduction mémorisés auparavant sont appliqués par le modificateur de signal (140) à un signal utile (142) à reproduire dans le mode de fonctionnement normal lorsqu'est présente une similitude ou une identité suffisante entre l'information de scénario d'écoute qui a été mémorisée en rapport avec les réglages de paramètres de reproduction mémorisés auparavant et la deuxième information de scénario d'écoute qui est présente à un moment actuel et qui décrit un scénario d'écoute actuel.

9. Dispositif de reproduction de son (100) selon l'une des revendications précédentes, comportant par ailleurs:
une entrée de signal acoustique pour un signal de bruit ambiant;
un analyseur de signal acoustique configuré pour déterminer l'information de scénario d'écoute sur base du signal de bruit ambiant.

10. Dispositif de reproduction de son (100) selon l'une des revendications précédentes, dans lequel les réglages de paramètres de reproduction comportent au moins l'un parmi: le réglage du volume sonore, le réglage du son, le réglage de la réponse de fréquence, le réglage de l'égaliseur, le réglage de la compression, le réglage de la balance et le réglage du curseur.

11. Dispositif de reproduction de son (100) selon l'une des revendications précédentes, comportant par ailleurs une interface de sortie qui est configurée pour transmettre des ensembles de données comportant le réglage de paramètres de reproduction et l'information de scénario d'écoute à un partenaire de communication externe.

12. Procédé d'apprentissage de paramètres de reproduction définis par l'utilisateur et fonction d'un scénario d'écoute pour un dispositif de reproduction de son (100), le procédé comprenant le fait de:
reproduire un signal acoustique utile (142) qui est mémorisé sur un support de mémoire;
évaluer une information de scénario d'écoute reçue;
simuler un scénario d'écoute qui correspond à l'information de scénario d'écoute reçue ou qui ressemble à cette dernière et qui influence une perception du signal sonore reproduit par un auditeur et/ou définit un type de signal utile;
recevoir les paramètres de reproduction définis par l'utilisateur qui représentent une préférence individuelle de l'auditeur en ce qui concerne le scénario d'écoute simulé;
modifier une reproduction du signal utile (142) selon les paramètres de reproduction définis par l'utilisateur reçus; et
mémoriser les paramètres de reproduction définis par l'utilisateur reçus et l'information de scénario d'écoute reçue les uns par rapport à l'autre;
**caractérisé par le fait que** seule la reproduction du signal utile est influencée, et non pas la reproduction d'un bruit de fond qui est reproduit ensemble avec le signal utile (142) dans le cadre du scénario d'écoute simulé.

13. Procédé selon la revendication 12, dans lequel la simulation du scénario d'écoute comporte la génération du bruit de fond qui est typique pour le scénario d'écoute.

14. Procédé selon la revendication 12 ou 13, dans lequel l'évaluation de l'information de scénario d'écoute reçue comporte une analyse du signal utile (142).

15. Procédé selon l'une des revendications 12 à 14, comportant par ailleurs le fait de:
commuter d'un mode d'apprentissage à un mode normal;
recevoir une deuxième information de scénario d'écoute qui est associée à un scénario d'écoute réel auquel l'auditeur est exposé à un moment pendant le fonctionnement normal;
mettre à disposition au moins un réglage de paramètres de reproduction préparé dont l'information de scénario d'écoute mémorisée y relative est suffisamment similaire ou identique à la deuxième information de scénario d'écoute;
déterminer un deuxième réglage de paramètres de reproduction sur base de l'au moins un réglage de paramètres de reproduction mis à disposition; et
modifier une reproduction d'un deuxième signal acoustique utile (142) selon le deuxième réglage de paramètres de reproduction.

16. Procédé selon la revendication 15, dans lequel la détermination du deuxième réglage de paramètres de reproduction comporte au moins l'un parmi: une interpolation, une évaluation de modèle, une évaluation d'un modèle psycho-acoustique et une évaluation d'une heuristique.

17. Programme d'ordinateur avec un code de programme pour réaliser le procédé selon l'une des revendications 12 à 16 lorsque le programme d'ordinateur est exécuté sur un ordinateur qui est connecté à un dispositif de reproduction de son selon l'une des revendications 1 à 11.
